# EUROPÄISCHE PATENTSCHRIFT

(11) **EP 2 063 229 B1**
(45) Veröffentlichungstag und Bekanntmachung des Hinweises auf die Patenterteilung: **02.05.2012**
(21) Anmeldenummer: 07022559.4
(22) Anmeldetag: 21.11.2007
(51) Int. Cl.: G01D 5/14, G01D 11/24, G01R 33/06, G01R 33/07, G01R 33/09, H01L 43/04, H01L 43/08

(54) **Magnetfeldsensoranordnung**
Magnetic field sensor system
Agencement de capteur de champ magnétique

(43) Veröffentlichungstag der Anmeldung: 27.05.2009
(73) Patentinhaber: Micronas GmbH, 79108 Freiburg i. Br. (DE)
(72) Erfinder: Kentsch, Carsten, Dipl.-Phys., 79112 Freiburg (DE)
(74) Vertreter: Koch, Bertram

(56) Entgegenhaltungen:
- EP-A- 0 537 419
- EP-A- 0 544 479
- EP-A- 0 680 103
- WO-A-2006/106454
- DE-A1- 4 200 466
- DE-A1- 19 620 548
- FR-A- 2 852 098
- US-A- 4 772 929
- US-A- 5 631 557
- US-A- 5 637 995
- US-A- 5 883 567
- US-A- 5 912 556
- US-A- 5 963 028
- US-A1- 2004 095 129
- DAUGHTON J: "Spin-dependent sensors" PROCEEDINGS OF THE IEEE, IEEE. NEW YORK, US, Bd. 91, Nr. 5, 1. Mai 2003 (2003-05-01), Seiten 681-686, XP011096630 ISSN: 0018-9219
- HSING-CHENG CHANG ET AL: "A Novel Electro-Optical Magnetic Microsensor with Reducing Interference Packaging" ELECTRONIC PACKAGING TECHNOLOGY, 2007. ICEPT 2007. 8TH INTERNATIONAL C ONFERENCE ON, IEEE, PI, 1. August 2007 (2007-08-01), Seiten 1-4, XP031209975 ISBN: 978-1-4244-1391-1
- POPOVIC ET AL: "CMOS magnetic sensors with integrated ferromagnetic parts" SENSORS AND ACTUATORS A, ELSEVIER SEQUOIA S.A., LAUSANNE, CH, Bd. 129, Nr. 1-2, 24. Mai 2006 (2006-05-24), Seiten 94-99, XP005427207 ISSN: 0924-4247
- BALTES H: "Future of IC microtransducers" SENSORS AND ACTUATORS A, ELSEVIER SEQUOIA S.A., LAUSANNE, CH, Bd. 56, Nr. 1, 1. August 1996 (1996-08-01), Seiten 179-192, XP004013031 ISSN: 0924-4247
- LENZ J E ET AL: "A high-sensitivity magnetoresistive sensor" 19900604; 19900604 - 19900607, 4. Juni 1990 (1990-06-04), Seiten 114-117, XP010000748
- DRAXELMAYR D ET AL: "A Chopped Hall Sensor With Small Jitter and Programmable True Power-On Function" IEEE JOURNAL OF SOLID-STATE CIRCUITS, IEEE SERVICE CENTER, PISCATAWAY, NJ, US, Bd. 40, Nr. 7, 1. Juli 2005 (2005-07-01), Seiten 1533-1540, XP011135461 ISSN: 0018-9200
- AHN C H ET AL: "A fully integrated micromagnetic actuator with a multilevel meander magnetic core" SOLID-STATE SENSOR AND ACTUATOR WORKSHOP, 1992. 5TH TECHNICAL DIGEST., IEEE HILTON HEAD ISLAND, SC, USA 22-25 JUNE 1992, NEW YORK, NY, USA,IEEE, US, 22. Juni 1992 (1992-06-22), Seiten 14-18, XP010056347 ISBN: 978-0-7803-0456-7
- ESASHI M ET AL: "Packaged micromechanical sensors" EMERGING TECHNOLOGIES AND FACTORY AUTOMATION, 1994. ETFA '94., IEEE SY MPOSIUM ON TOKYO, JAPAN 6-10 NOV. 1994, NEW YORK, NY, USA,IEEE, 6. November 1994 (1994-11-06), Seiten 30-37, XP010139977 ISBN: 978-0-7803-2114-4
- DANIEL J SADLER ET AL: "MICROMACHINED SEMI-ENCAPSULAED SPIRAL INDUCTORS FOR MICRO ELECTRO MECHANICAL SYSTEMS (MEMS) APPLICATIONS" IEEE TRANSACTIONS ON MAGNETICS, IEEE SERVICE CENTER, NEW YORK, NY, US, Bd. 33, Nr. 5, 1. September 1997 (1997-09-01), Seiten 3319-3321, XP011086140 ISSN: 0018-9464
- JAMES M DAUGHTON: "GMR and SDT Sensor Applications" IEEE TRANSACTIONS ON MAGNETICS, IEEE SERVICE CENTER, NEW YORK, NY, US, Bd. 36, Nr. 5, 1. September 2000 (2000-09-01), XP011032900 ISSN: 0018-9464

## Beschreibung

Die Erfindung betrifft eine Magnetfeldsensoranordnung mit mindestens einem, in einen Halbleiterchip integrierten Magnetfeldsensor und mit wenigstens einer Magnetfeldquelle, wobei der Halbleiterchip und die wenigstens eine Magnetfeldquelle in einem Umkapselungsmaterial derart in einer vorbestimmten Lage relativ zueinander angeordnet sind, dass ein von der Magnetfeldquelle erzeugtes Magnetfeld mit Hilfe des mindestens einen Magnetfeldsensors detektierbar ist.

Eine derartige Magnetfeldsensoranordnung ist aus US 5 963 028 bekannt. Sie hat als Magnetfeldquelle einen als Stabmagnet ausgestalteten Permanentmagnet. Auf einer stirnseitigen Polfläche des Permanentmagnets ist ein flächiges metallisches Trägerplättchen angeordnet, dass mit einer seiner Unterseite flächig an der Polfläche des Permanentmagnets anliegt Auf der Oberseite des Trägerplättchens ist ein Halbleiterchip etwa mittig zur der Polfläche angeordnet, der sich parallel zu dem Trägerplättchen und der Polfläche erstreckt und mit seiner Rückseite flächig an dem Trägerplättchen anliegt. In den Halbleiterchip ist als Magnetfeldsensor ein Hall-Sensor integriert.

An seiner dem Permanentmagnet abgewandten Vorderseite hat der Halbleiterchip drei elektrischen Anschlussstellen, die mit Bonddrähten verbunden sind. Ein erster Bonddraht ist an einer mit dem Trägerplättchen einstückig verbundenen ersten Kontaktfahne, ein zweiter Bonddraht an einer zweiten Kontaktfahne und ein dritter Bonddraht an einer dritten Kontaktfahne angeordnet Der Permanentmagnet, das Trägerplättchen und der Halbleiterchip sind vollständig und die Kontaktfahnen teilweise mit einer elektrisch isolierenden Vergussmasse umkapselt. Zum Verbinden mit externen elektrischen Leitern oder Anschlüssen ragen die Kontaktfahnen mit ihren von den Bonddrähten entfernten Endbereichen aus der Vergussmasse heraus.

Der Magnetfeldsensoranordnung ist ein rotierendes Zahnrad zugeordnet, das aus einem weichmagnetischen Werkstoff besteht. Die Magnetfeldsensoranordnung ist am Außenumfang eines Zahnrads angeordnet und derart durch einen Luftspalt von dem Zahnrad beabstandet, dass der von dem Permanentmagnet erzeugte magnetische Fluss durch das Zahnrad hindurchfließt Je nach dem, ob ein Zahn oder eine Zahnlücke an dem Hallsensor positioniert ist, ergibt sich in diesem ein unterschiedlicher magnetischer Fluss. Mit Hilfe der Magnetfeldsensoranordnung kann die Drehbewegung des Zahnrads detektiert werden.

Da die Magnetfeldquelle bereits in die Magnetfeldsensoranordnung integriert ist, kann eine zusätzliche Magnetfeldquelle und somit ein entsprechender Montage- und Justieraufwand eingespart werden. Ungünstig ist jedoch, dass die Magnetfeldsensoranordnung relativ große Abmessungen aufweist. Daher ist sie beispielsweise für den Einbau in einen schmalen Spalt praktisch nicht geeignet.

Aus der FR 2 852 098, der EP 0 537 419, der EP 0 544 479 und der US 4 772 929 sind Anordnungen bekannt bei denen unter anderem auch die Integration eines Permanentmagneten offenbart ist. Des Weiteren sind aus Daughton, J: "Spin-dependent sensors" Proceedings of the IEEE, IEEE, New York, US Bd. 91 , Nr.. 5, 1. Mai 2003, Seiten 681-686, aus Hsing-Cheng Chang et al,: "A novel Electro-optical Magnetic Microsensor with reducing interference Packaging", Electronic Packaging Technology, 2007, ICEPT 2007. 8th International Conference on, IEEE, PI, 1 August, Seiten 1-4, aus Popovic et al: "CMOS magnetic sensors with integrated ferromagnetic parts " SENSORS and Actuators A, EIsevier Sequoia S. A., Lausanne, CH, Bd. 129, Nr. 1-2, 24. Mai 2006, Seiten 94-99, aus Baltes H:"Future of IC microtransducers" Sensors and Actuators A, Elsevier Sequoia S. A., Lausanne, CH, Bd. 96, 1996, Seiten 179-192 und aus Lenz J et al: "A high-sensitivity magnetoresistive sensor". 4 Juni 1990, Seiten 114-117, weitere Anordnungen offenbart.

Es besteht deshalb die Aufgabe, eine Magnetfeldsensoranordnung der eingangs genannten Art zu schaffen, die eine flache Bauform ermöglicht.

Erfindungsgemäß wird diese Aufgabe dadurch gelöst, dass die Magnetfeldquelle in dem Halbleiterchip und/oder in der Erstreckungsebene des Halbleiterchips seitlich neben diesem angeordnet ist, dass der Magnetfelsensor ein Hall-Sensor ist und dass wenigstens eine mit einer verstellbaren Stromquelle verbundene Kalibrierspule vorgesehen ist und die Kalibrierspule in den Halbleiterchip integriert ist.

In vorteilhafter Weise ist es dadurch möglich, die Bauhöhe der Magnetfeldsensoranordnung auf die Baureihe eines entsprechenden Halbleiterbauelements, das keine Magnetfeldquelle beinhaltet, zu reduzieren. Dennoch können magnetisch leitfähige Werkstoffe, die in den Wirkungsbereich des von der Magnetfeldquelle erzeugten magnetischen Felds gelangen und lassen Flussdichte verändern, mit Hilfe des Magnetfeldsensors auf einfache Weise detektiert werden.

Bei einer vorteilhaften Ausgestaltung der Erfindung weist die mindestens eine Magnetfeldquelle einen Permanentmagneten auf. Dadurch wird ein relativ großer magnetischer Fluss und somit eine hohe Messempfindlichkeit der Magnetfeldsensoranordnung ermöglicht.

Bei einer anderen zweckmäßigen Ausführungsform der Erfindung weist die mindestens eine Magnetfeldquelle eine Feldspule auf, die mit einem Stromversorgungsanschluss verbunden ist. Der magnetische Fluss kann dann in Abhängigkeit von der jeweiligen Anwendung durch entsprechendes Bestromen der Feldspule eingestellt werden. Dabei ist es sogar möglich, dass die Feldspule zum Erzeugen eines magnetischen Wechselfelds mit einer Wechselstromquelle verbunden ist und dass als Magnetfeldsensor eine Messspule vorgesehen ist. Die Stromversorgung der Feldspule kann von einer in den Halbleiterchip integrierten Steuereinrichtung gesteuert sein.

Bei einer Weiterbildung der Erfindung ist vorgesehen, dass mindestens zwei Magnetfeldquellen in dem Umkapselungsmaterial angeordnet sind, und dass der Halbleiterchip zwischen diesen Magnetfeldquellen vorgesehen ist. Dadurch ergibt sich ein symmetrischer Aufbau, der im Bereich des Magnetfeldsensors bei Annäherung der Magnetfeldsensoranordnung an einen ferromagnetischen Gegenstand und/oder beim Entfernen der Magnetfeldsensoranordnung von dem ferromagnetischen Gegenstand eine starke Veränderung des magnetischen Flusses und somit eine hohe Messempfindlichkeit ermöglicht.

Vorteilhaft ist, wenn die Magnetfelder der mindestens zwei Magnetfeldquellen derart orientiert sind, dass sie sich an dem Magnetfeldsensor zumindest teilweise kompensieren. Dabei ist es sogar möglich, dass die Magnetisierungsrichtung von mindestens zwei Magnetfeldquellen in und/oder parallel zur Erstreckungsebene des Halbleiterchips angeordnet ist, und dass diese Magnetfeldquellen in entgegengesetzte Richtung magnetisiert sind, so dass der magnetische Fluss in dem Magnetfeldsensor etwa gleich Null ist, wenn kein magnetisch leitfähiger und/oder magnetischer Werkstoff im Wirkungsbereich der Magnetfeldquellen angeordnet ist. Das Messsignal des Magnetfeldsensors kann dann mittels eines Messverstärkers relativ stark verstärkt werden. Die Magnetfeldsensoranordnung reagiert dann noch empfindlicher auf Veränderungen der magnetischen Leitfähigkeit und/oder Fremdmagnetfelder in ihrer Umgebung.

Bei einer bevorzugten Ausgestaltung der Erfindung ist die Kalibrierspule dem mindestens einen Permanentmagnet zum Kalibrieren des Magnetfelds zugeordnet, wobei der Magnetfeldsensor im magnetischen Wirkungsbereich der Kalibrierspule angeordnet ist. Mit Hilfe der wenigstens einen Kalibrierspule können dann Toleranzen in der Magnetisierung des Permanentmagnets kompensiert werden. Dabei ist es sogar denkbar, dass um den Magnetfeldsensor herum mehrere Kalibrierspulen, die jeweils mittels einer ihr zugeordneten Stromquelle ansteuerbar sind, angeordnet sind. Dabei sind die Kalibrierspulen vorzugsweise in unterschiedlichen Sektoren vorgesehen. Wenn aus unterschiedlichen Richtungen ein ferromagnetischer Körper an den Magnetfeldsensor angenähert wird, kann mit Hilfe der in den unterschiedlichen Sektoren befindlichen Kalibrierspulen eine vorbestimmte Detekfionsempfindlichkeit erreicht werden, insbesondere eine symmetrische Detektionsempfindlichkeit. Die Magnetfeldsensoranordnung kann beispielsweise für absolute Abstandsmessungen verwendet werden.

Vorteilhaft ist, wenn die Feldspule in den Halbleiterchip integriert ist. Die Magnetfeldsensoranordnung ermöglicht dann einen noch kompakteren und kostengünstigeren Aufbau. Die Feldspule kann Leiterbahnen aufweisen, die in zwei oder mehr Ebenen des Halbleiterchips angeordnet und über Durchkontaktierungen miteinander verbunden sind.

Bei einer zweckmäßigen Ausführungsform der Erfindung sind mindestens vier Magnetfeldquellen in dem Umkapselungsmaterial um den Halbleiterchip herum angeordnet, vorzugsweise in gleichen Winkelabständen zueinander. Wenn die Magnetfelder der einzelnen Magnetfeldquellen in dieselbe Richtung orientiert sind, ergibt sich dann um den Magneifeldsensor herum eine weitgehend symmetrische magnetische Flussdichte. Es ist aber auch denkbar, dass mindestens zwei Magnetfeldquellen in entgegengesetzte Richtungen magnetisiert sind, um entlang einer um den Magnetfeldsensor herumführenden Linie eine asymmetrische magnetische Flussdichte zu erreichen.

Bei einer anderen Ausgestaltung der Erfindung umgrenzt die Magnetfeldquelle den mindestens einen Magnetfeldsensor ringförmig. Dadurch wird um den Magnetfeldsensor herum eine noch gleichmäßigere Verteilung der magnetischen Flussdichte ermöglicht.

Die mindestens eine Magnetfeldquelle und/oder die Kalibrierspule kann (können) mit ihrer Magnetisierungsachse in und/oder parallel zu der Erstreckungsebene des Halbleiterchips angeordnet sein. Der Magnetfeldsensor weist dann bevorzugt parallel zur Magnetisierungsachse seine größte Messempfindlichkeit auf Als Magnetfeldsensor ist dabei bevorzugt mindestens ein vertikaler Hallsensor vorgesehen. Es ist aber auch denkbar, dass der Magnetfeldsensor ein magnetoresistiver Sensor ist.

Die mindestens eine Magnetfeldquelle und/oder die Kalibrierspule kann (können) mit ihrer Magnetisierungsachse auch orthogonal zur Erstreckungsebene des Halbleiterchips angeordnet sein. Dabei kann als Magnetfeldsensor ein horizontaler Hallsensor vorgesehen sein.

Zweckmäßigerweise ist in den Halbleiterchip eine Ansteuerungs- und/oder Auswerteeinrichtung integriert, die zumindest einen mit dem mindestens einen Magnetfeldsensor verbunden Messsignaleingang aufweist. Die Auswerteeinrichtung kann eine Vergleichseinrichtung zum Vergleichen des Messsignals des mindestens einen Magnetfeldsensors mit einem Sollwert oder Sollwertbereich und/oder Filter zum Unterdrücken von Störsignalen aufweisen.

Bei einer vorteilhaften Ausgestaltung der Erfindung ist mindestens eine Feldspule zum Erzeugen eines magnetischen Wechselfelds an einer Wechselstromquelle angeschlossen und die Ansteuerungs- und/oder Auswerteeinrichtung weist eine Korrelationseinrichtung auf, die einen ersten, mit dem mindestens einen Magnetfeldsensor verbundenen Eingang und einen zweiten, mit der Wechselstromquelle verbunden Eingang hat. Die Magnetfeldsensoranordnung ist dann gegen magnetische Störfelder weitgehend unempfindlich.

Nachfolgend sind Ausführungsbeispiele der Erfindung anhand der Zeichnung näher erläutert Es zeigt
- Fig. 1 und 2: eine Magnetfeldsensoranordnung, die in einem Umkapselungsma- terial einen in einen Halbleiterchip integrierten Magneifeldsensor und eine Magnetfeldquelle aufweist,
- Fig. 3 und 4: eine Magnetfeldsensoranordnung, bei dem im Umkapselungsmate- rial zwei Magnetfeldquellen vorgesehen sind, zwischen denen der Halbleiterchips angeordnet ist,
- Fig. 5: eine Magnetfeldsensoranordnung, bei dem im Umkapselungsmate- rial vier Magnetfeldquellen um den Halbleiterchip herum angeord- net sind, und
- Fig. 6: eine Aufsicht auf einen Halbleiterchip, in den ein Magnetfeldsensor, eine Kalibrierspule und eine Ansteuerungs- und Auswerteeinrichtung integriert sind, wobei im Inneren des Halbleiterchips befindliche Lei- terbahnen strichliniert dargestellt sind.

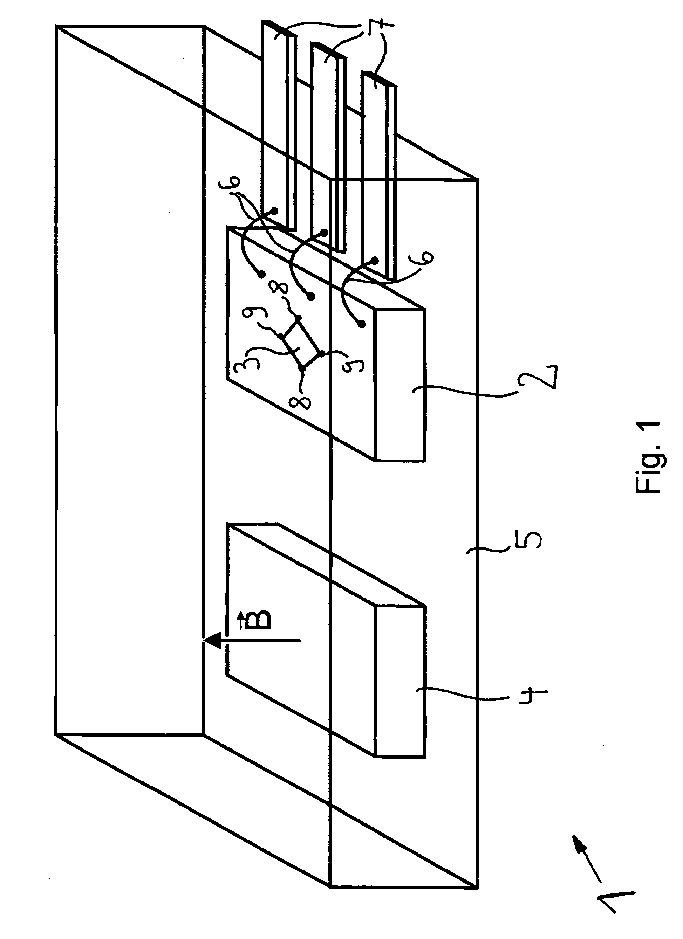

Eine in Fig. 1 im Ganzen mit 1 bezeichnete Magnetfeldsensoranordnung weist einen in einen Halbleiterchip 2 integrierten Magnetfeldsensor 3 auf, der im Magnetfeld einer permanentmagnetischen Magnetfeldquelle 4 angeordnet ist. Anstelle der permanentmagnetischen Magnetfeldquelle 4 kann auch eine mit einer Stromquelle verbundene Feldspule vorgesehen sein.

Der Halbleiterchip 2 und die Magnetfeldquelle 4 sind in ein Umkapselungsmaterial 5 eingebettet, beispielsweise in Kunststoff. Der Halbleiterchip 2 hat mehrere Anschlussstellen, die jeweils über einen Bonddraht 6 mit einem elektrischen Anschlusskontakt 7 verbunden sind. Die Anschlusskontakte 7 haben jeweils einen, dem Halbleiterchip 2 zugewandten ersten Abschnitt, der mit dem Umkapselungsmaterial 5 dicht umspritzt ist. Ein von dem Halbleiterchip 2 beabstandeter zweiter Abschnitt des Anschlusskontakts 7 ragt aus dem Umkapselungsmaterial 5 heraus und kann mit elektrischen Leitungen verbunden werden.

Der Magnetfeldsensor 3 ist als Hall-Sensor ausgestaltet, der eine Hall-Platte aufweist, die zwei in der Erstreckungsebene des Halbleiterchips 2 diametral einander gegenüberliegende erste Anschlüsse 8 zum Einspeisen eines Messstroms aufweist. Die ersten Anschlüsse 8 sind mit einer in Fig. 1 nicht näher dargestellten, in den Halbleiterchip 2 integrierten Messstromquelle verbunden.

Außerdem hat die Hall-Platte zwei in der Erstreckungsebene des Halbleiterchips 2 diametral einander gegenüberliegende zweite Anschlüsse 9, die mit einem hochohmigen, in den Halbleiterchip 2 integrierten Messverstärker verbunden sind.

In Fig. 1 ist deutlich erkennbar, dass die Magnetfeldquelle 4 in der Erstreckungsebene des Halbleiterchips 2 seitlich neben diesem angeordnet und durch das Umkapselungsmaterial 5 von diesem beabstandet ist. Es ist aber auch denkbar, dass der Halbleiterchips 2 seitlich direkt an die Magnetfeldquelle 4 angrenzt.

Bei dem in Fig. 1 abgebildeten Ausführungsbeispiel ist die Magnetfeldquelle 4 quer und vorzugsweise normal zur Erstreckungsebene des Halbleiterchips 2 magnetisiert. Als Magnetfeldsensor 3 ist eine so genannter horizontaler Hall-Sensor vorgesehen, dessen Hall-Platte in der Erstreckungsebene des Halbleiterchips 2 angeordnet ist.

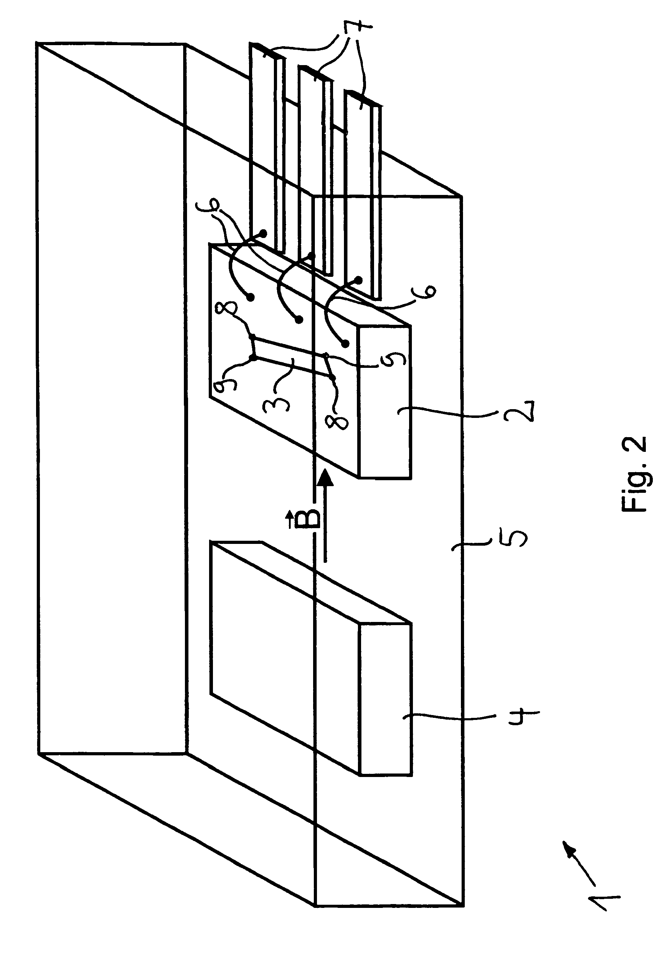

Bei dem in Fig. 2 dargestellten Ausführungsbeispiel ist die Magnetfeldquelle 4 parallel zur Erstreckungsebene des Halbleiterchips 2 magnetisiert. Dabei verlauft die Magnetisierungsrichtung der Magnetfeldquelle 4 etwa in Richtung einer die Magnetfeldquelle 4 mit dem Magnetfeldsensor 3 verbindenden geraden Linie. Es sind aber auch andere Ausführungsformen denkbar, bei denen die Magnetisierungsrichtung der Magnetfeldquelle 4 in der Erstreckungsebene des Halbleiterchips 2 nicht auf einer solchen Verbindungslinie verläuft. Als Magnetfeldsensor 3 ist in Fig. 2 ein vertikaler Hall-Sensor vorgesehen, dessen Hall-Platte etwa normal zur Erstreckungsebene des Halbleiterchips 2 angeordnet ist.

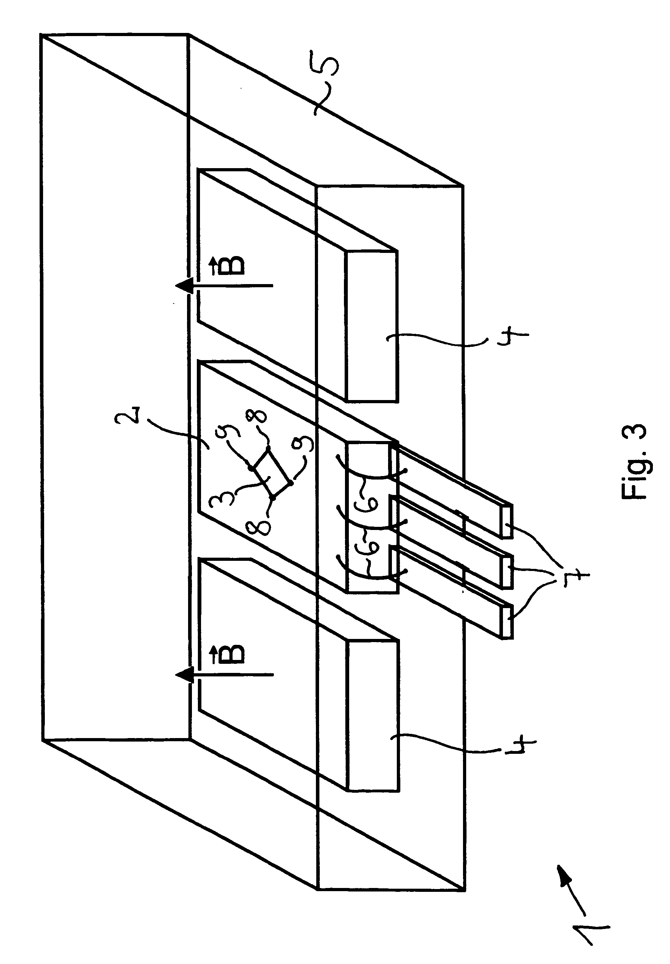

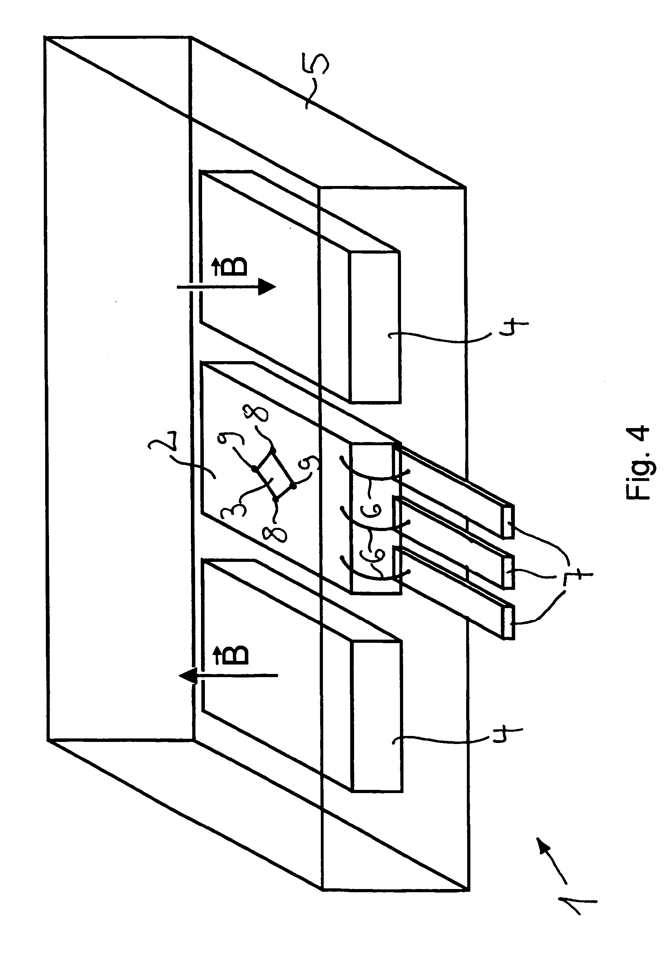

Bei den in Fig. 3 und 4 gezeigten Ausftihrungsbeispielen sind jeweils zwei Magnetfeldquellen 4 in dem Umkapselungsmaterial 5 angeordnet. Dabei ist der Halbleiterchip 2 etwa mittig zwischen diesen Magnetfeldquellen 4 positioniert. Deutlich ist erkennbar, dass der Halbleiterchip 2 und die Magnetfeldquellen 4 etwa in derselben Ebene angeordnet sind.

Bei dem Ausführungsbeispiel gemäß Fig. 3 ist die Magnetisierung der Magnetfeldquellen 4 in dieselbe Richtung orientiert und derart gewählt, dass der magnetische Fluss in dem Magnetfeldsensor 3 gegenüber einer entsprechenden Anordnung mit nur einer Magnetfeldquellen 4 vergrößert ist. Wenn in die Nähe der Magnetfeldsensoranordnung 1 ein ferromagnetisch leitfähiger Körper gebracht wird, wird die Symmetrie des magnetischen Feldes gestört, so dass der Magnetfeldsensor 3 dann von einem magnetischen Fluss durchströmt wird. Das Messsignal des Magnetfeldsensors 3 verändert sich dann entsprechend.

Bei dem in Fig. 4 gezeigten Ausführungsbeispiel sind die beiden beidseits des Magnetfeldsensors 3 angeordneten Magnetfeldquellen 4 derart in zueinander entgegengesetzte Richtung orientiert, dass der magnetische Fluss an dem Magnetfeldsensor 3 etwa gleich null ist, wenn in der Umgebung der Magnetfeldsensoranordnung 1 kein ferromagnetisch leitfähiges Material angeordnet ist. Wenn in die Umgebung der Magnetfeldsensoranordnung 1 ein ferromagnetisch leitfähiger Körper gebracht oder aus dieser entfernt wird, verändert sich die magnetische Flussdichte an dem Magnetfeldsensor 3.

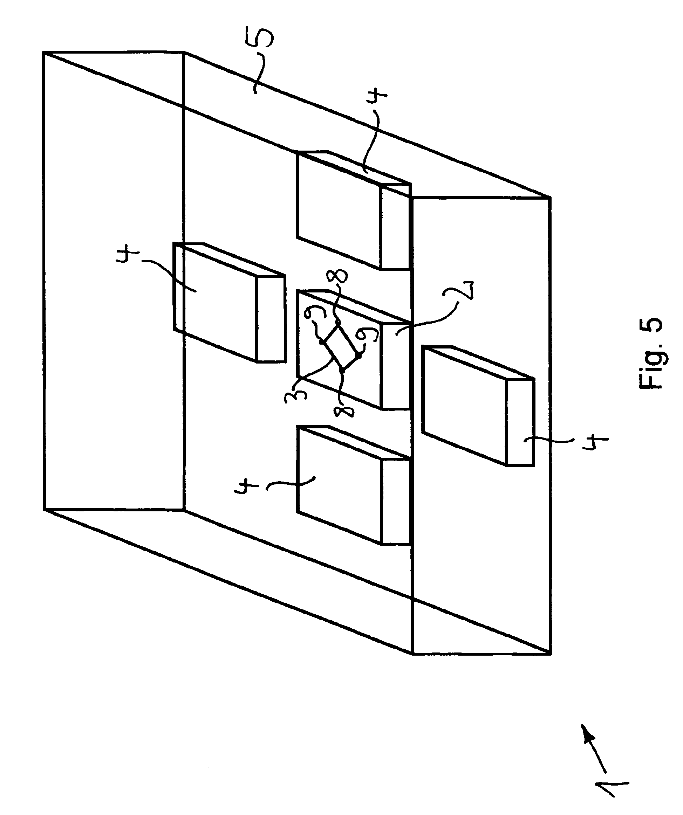

Bei dem in Fig. 5 gezeigten Ausführungsbeispiel sind vier Magnetfeldquellen 4 in dem Umkapselungsmaterial 5 in gleichen Abständen um den Magnetfeldsensor 3 herum angeordnet. Dabei sind die einzelnen Magnetfeldsensoren 3 jeweils um 90° zueinander versetzt. Die Magnetfeldsensoren 3 und der Halbleiterchip 2 sind wiederum in derselben Ebene angeordnet. Zueinander benachbarte Magnetfeldquellen 4 können in dieselbe oder in zueinander entgegengesetzte Richtungen magnetisiert sein.

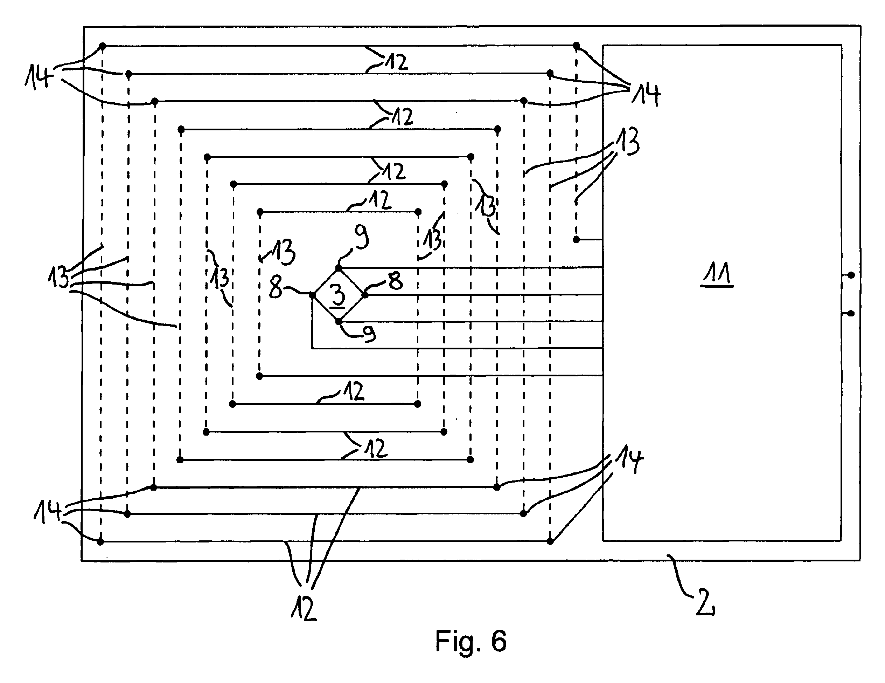

Bei dem in Fig. 6 gezeigten Ausführungsbeispiel ist der mindestens einen permanentmagnetischen Magnetfeldquelle 4 eine Kalibrierspule 10 zugeordnet, mit welcher der magnetische Fluss in dem Magnetfeldsensor 3 kalibrierbar ist, beispielsweise um magnetische Fertigungstoleranzen der Magnetfeldquelle(n) 4 auszugleichen. Die Kalibrierspule 10 ist mit einer verstellbaren Stromquelle verbunden, die in einer in der Zeichnung nur schematisch dargestellten Ansteuerungs- und/oder Auswerteeinrichtung 11 vorgesehen ist. Die Kalibrierspule 10 ist in den Halbleiterchip 2 integriert und weist mehrere parallel zueinander verlaufende erste Leiterbahnen 12 auf, die in einer ersten Leiterbahnebene angeordnet sind. In einer zweiten Leiterbahnebene sind mehrere parallel zueinander verlaufende zweite Leiterbahnen 13 vorgesehen, die über Durchkontaktierungen 14 mit den ersten Leiterbahnen 12 in Reihe geschaltet sind. Die Windungen der Kalibrierspule 10 umgrenzen den Magnetfeldsensor 3.

Bei dem in Fig. 6 gezeigten Ausführungsbeispiel verläuft das von der Kalibrierspule 10 erzeugte Magnetfeld etwa orthogonal zur Erstreckungsebene des Halbleiterchips 2. Es sind aber auch Kalibrierspulen 10 denkbar, bei denen die Spulenwindungen derart in Metallisierungsebenen des Halbleiterchips 2 angeordnet sind, dass das Magnetfeld in der Erstreckungsebene des Halbleiterchips 2 und/oder parallel dazu verläuft.

Erwähnt werden soll noch, dass die Ansteuerungs- und/oder Auswerteeinrichtung 11 eine Betriebsartenumschalteinrichtung aufweisen kann, mittels der die Kalibrierspule 10 wahl- oder wechselweise mit der Stromquelle oder dem Messverstärker verbindbar ist. Bei Anwendungen, für die eine Kalibrierung des Magnetfelds nicht erforderlich ist, kann dann die Kalibrierspule 10 mit dem Messverstärker verbunden sein, um die durch das magnetische Feld in der Kalibrierspule 10 induzierte elektrische Spannung zu messen.

## Patentansprüche

1. Magnetfeldsensoranordnung (1) mit mindestens einem, in einen Halbleiterchip (2) integrierten Magnetfeldsensor (3) und mit wenigstens einer Magnetfeldquelle (4), die in der Erstreckungsebene des Halbleiterchips (2) seitlich neben diesem angeordnet ist, wobei der Halbleiterchip (2) und die wenigstens eine Magnetfeldquelle (4) in einem Umkapselungsmaterial (5) derart in einer vorbestimmten Lage relativ zueinander angeordnet sind, dass ein von der Magnetfeldquelle (4) erzeugtes Magnetfeld mit Hilfe des mindestens einen Magnetfeldsensors (3) detektierbar ist, **dadurch gekennzeichnet, dass** der mindestens eine Magnetfeldsensor (3) ein Hall-Sensor ist, dass die Magnetfeldquelle (4) seitlich von dem Halbleiterchip (2) beabstandet ist, und
dass
wenigstens eine mit einer verstellbaren Stromquelle verbundene Kalibrierspule (10) vorgesehen ist und die Kalibrierspule (10) in den Halbleiterchip (2) integriert ist.

2. Magnetfeldsensoranordnung (1) nach Anspruch 1, **dadurch gekennzeichnet, dass** die mindestens eine Magnetfeldquelle (4) einen Permanentmagneten aufweist.

3. Magnetfeldsensoranordnung (1) nach Anspruch 1 oder 2, **dadurch gekennzeichnet, dass** die mindestens eine Magnetfeldquelle (4) eine Feldspule aufweist, die mit einem Stromversorgungsanschluss verbunden ist.

4. Magnetfeldsensoranordnung (1) nach einem der Ansprüche 1 bis 3, **dadurch gekennzeichnet, dass** mindestens zwei Magnetfeldquellen (4) in dem Umkapselungsmaterial (5) angeordnet sind, und dass der Halbleiterchip (2) zwischen diesen Magnetfeldquellen (4) vorgesehen ist.

5. Magnetfeldsensoranordnung (1) nach Anspruch 4, **dadurch gekennzeichnet, dass** die Magnetfelder der mindestens zwei Magnetfeldquellen (4) derart orientiert sind, dass sie sich an dem Magnetfeldsensor (3) zumindest teilweise kompensieren.

6. Magnetfeldsensoranordnung (1) nach einem der Ansprüche 2 bis 5, **dadurch gekennzeichnet, dass** die Kalibierspule (10) mindestens einem Permanentmagnet zum Kalibrieren des Magnetfelds zugeordnet ist, und dass der Magnetfeldsensor (3) im magnetischen Wirkungsbereich der Kalibrierspule (10) angeordnet ist.

7. Magnetfeldsensoranordnung (1) nach einem der Ansprüche 3 bis 6, **dadurch gekennzeichnet, dass** die Feldspule in den Halbleiterchip (2) integriert ist.

8. Magnetfeldsensoranordnung (1) nach einem der Ansprüche 1 bis 7, **dadurch gekennzeichnet, dass** mindestens vier Magnetfeldquellen (4) in dem Umkapselungsmaterial (5) um den Halbleiterchip (2) herum angeordnet sind, vorzugsweise in gleichen Winkelabständen zueinander.

9. Magnetfeldsensoranordnung (1) nach einem der Ansprüche 1 bis 8, **dadurch gekennzeichnet, dass** die Magnetfeldquelle (4) den mindestens einen Magnetfeldsensor (3) ringförmig umgrenzt.

10. Magnetfeldsensoranordnung (1) nach einem der Ansprüche 1 bis 9, **dadurch gekennzeichnet, dass** die mindestens eine Magnetfeldquelle (4) und/oder Kalibrierspule (10) mit ihrer Magnetisierungsachse in und/oder parallel zu der Erstreckungsebene des Halbleiterchips (2) angeordnet ist.

11. Magnetfeldsensoranordnung (1) nach einem der Ansprüche 1 bis 10, **dadurch gekennzeichnet, dass** die mindestens eine Magnetfeldquelle (4) und/oder die Kalibrierspule (10) mit ihrer Magnetisierungsachse orthogonal zur Erstreckungsebene des Halbleiterchips (2) angeordnet ist.

12. Magnetfeldsensoranordnung (1) nach einem der Ansprüche 1 bis 11, **dadurch gekennzeichnet, dass** mindestens ein Magnetfeldsensor (3) ein horizontaler Hallsensor und/oder ein vertikaler Hallsensor ist.

13. Magnetfeldsensoranordnung (1) nach einem der Ansprüche 1 bis 12, **dadurch gekennzeichnet, dass** in den Halbleiterchip (2) eine Ansteuerungs- und / oder Auswerteeinrichtung (11) integriert ist, die zumindest einen mit dem mindestens einen Magnetfeldsensor (3) verbunden Messsignaleingang aufweist.

14. Magnetfeldsensoranordnung (1) nach einem der Ansprüche 3 bis 13, **dadurch gekennzeichnet, dass** mindestens eine Feldspule zum Erzeugen eines magnetischen Wechselfelds an einer Wechselstromquelle angeschlossen ist und dass die Ansteuerungs- und/oder Auswerteeinrichtung (11) eine Korrelationseinrichtung aufweist, die einen ersten, mit dem mindestens einen Magnetfeldsensor (3) verbundenen Eingang und einen zweiten, mit der Wechselstromquelle verbunden Eingang aufweist.

## Claims

1. Magnetic field sensor arrangement (1) with at least one magnetic field sensor (3) integrated in a semiconductor chip (2) and with at least one magnetic field source (4) arranged in the plane of extension of the semiconductor chip (2) laterally adjacent thereto, wherein the semiconductor chip (2) and the at least one magnetic field source (4) are so arranged in an encapsulating material (5) in a predetermined position relative to one another that a magnetic field generated by the magnetic field source (4) is detectable with the help of the at least one magnetic field sensor (3), **characterised in that** the at least one magnetic field sensor (3) is a Hall sensor, that the magnetic field source (4) is laterally spaced from the semiconductor chip (2) and that at least one calibrating coil (10) connected with an adjustable current source is provided, the calibrating coil (10) being integrated in the semiconductor chip (2).

2. Magnetic field sensor arrangement (1) according to claim 1, **characterised in that** the at least magnetic field source (4) comprises a permanent magnet.

3. Magnetic field sensor arrangement (1) according to claim 1 or 2, **characterised in that** the at least one magnetic field source (4) comprises a field coil which is connected with a current supply connection.

4. Magnetic field sensor arrangement (1) according to any one of claims 1 to 3, **characterised in that** at least two magnetic field sources (4) are arranged in the encapsulating material (5) and that the semiconductor chip (2) is provided between these magnetic field sources (4).

5. Magnetic field sensor arrangement (1) according to claim 4, **characterised in that** the magnetic fields of the at least two magnetic field sources (4) are so oriented that they are at least in part mutually compensating at the magnetic field sensor (3).

6. Magnetic field sensor arrangement (1) according to any one of claims 2 to 5, **characterised in that** the calibrating coil (10) is associated with at least one permanent magnet for calibrating the magnetic field and that the magnetic field sensor (3) is arranged in the magnetically effective region of the calibrating coil (10).

7. Magnetic field sensor arrangement (1) according to any one of claims 3 to 6, **characterised in that** the field coil is integrated in the semiconductor chip (2).

8. Magnetic field sensor arrangement (1) according to any one of claims 1 to 7, **characterised in that** at least four magnetic field sources (4) are arranged in the encapsulating material (5) around the semiconductor chip (2), preferably at the same angular spacings from one another.

9. Magnetic field sensor arrangement (1) according to any one of claims 1 to 8, **characterised in that** the magnetic field source (4) annularly surrounds the at least one magnetic field sensor (3).

10. Magnetic field sensor arrangement (1) according to any one of claims 1 to 9, **characterised in that** the at least one magnetic field source (4) and/or calibrating coil (10) is or are arranged with the magnetising axis or axes thereof in and/or parallel to the plane of extension of the semiconductor chip (2).

11. Magnetic field sensor arrangement (1) according to any one of claims 1 to 10, **characterised in that** the at least one magnetic field source (4) and/or the calibrating coil (10) is or are arranged with the magnetising axis or axes thereof orthogonal to the plane of extension of the semiconductor chip (2).

12. Magnetic field sensor arrangement (1) according to any one of claims 1 to 11, **characterised in that** at least one magnetic field sensor (3) is a horizontal Hall sensor and/or a vertical Hall sensor.

13. Magnetic field sensor arrangement (1) according to any one of claims 1 to 12, **characterised in that** integrated in the semiconductor chip (2) is an activating and/or evaluating device (11) which comprises at least one measurement signal input connected with the at least one magnetic field sensor (3).

14. Magnetic field sensor arrangement (1) according to any one of claims 3 to 13, **characterised in that** at least one field coil for generating a magnetic alternating field is connected with an alternating current source and that the activating and/or evaluating device (11) comprises a correlation device which has a first input connected with the at least one magnetic field sensor (3) and second input connected with the alternating current source.

## Revendications

1. Agencement de capteur de champ magnétique (1) avec au moins un capteur de champ magnétique (3) intégré dans une puce semi-conductrice (2) et au moins une source de champ magnétique (4) qui est placée latéralement à côté de celui-ci dans le plan de développement de la puce conductrice (2), la puce semi-conductrice et la au moins une source de champ magnétique (4) étant placées à l'intérieur d'un matériau d'encapsulation (5) de façon à occuper un emplacement relativement proche l'une de l'autre pour qu'un champ magnétique généré par la source de champ magnétique (4) soit détectable à l'aide d'au moins un capteur de champ magnétique (3) **caractérisé en ce que**
. l'au moins un capteur de champ magnétique (3) est un capteur à effet Hall
. la source de champ magnétique (4) est placée latéralement à intervalle de la puce semi-conductrice (2)
et qu'il présente au moins une bobine de calibrage (10) reliée à une source de courant réglable et que la bobine de calibrage (10) est intégrée dans la puce semi-conductrice.

2. Agencement de capteur de champ magnétique (1) selon la revendication 1 **caractérisé en ce que** la au moins source de champ magnétique (4) présente un aimant permanent.

3. Agencement de capteur de champ magnétique (1) selon la revendication 1 ou 2 **caractérisé en ce que** la au moins source de champ magnétique (4) présente une bobine de champ qui est reliée à une connexion d'alimentation en courant.

4. Agencement de capteur de champ magnétique (1) selon l'une des revendications 1 à 3 **caractérisé en ce qu'**au moins deux sources de champ magnétique (4) sont placées dans le matériau d'encapsulation (5) et **en ce que** la puce semi-conductrice (2) est prévue entre ces sources de champ magnétique (4).

5. Agencement de capteur de champ magnétique (1) selon la revendication 4 **caractérisé en ce que** les champs magnétiques des au moins deux sources de champ magnétique (4) sont orientés de telle façon qu'ils se compensent au moins partiellement au niveau du capteur de champ magnétique (3).

6. Agencement de capteur de champ magnétique (1) selon l'une des revendications 2 à 5 **caractérisé en ce que** la bobine de calibration (10) est attribuée à au moins un aimant permanent pour le calibrage du champ magnétique et **en ce que** le capteur de champ magnétique (3) est disposé dans la zone d'effet magnétique de la bobine de calibrage (10).

7. Agencement de capteur de champ magnétique (1) selon l'une des revendications 3 à 6 **caractérisé en ce que** la bobine de champ magnétique est intégrée dans la puce semi-conductrice (2).

8. Agencement de capteur de champ magnétique (1) selon l'une des revendications 1 à 7 **caractérisé en ce qu'**au moins quatre sources de champ magnétique (4) sont disposées dans le matériau d'encapsulation autour de la puce semi-conductrice (2), de préférence selon des intervalles angulaires mutuels identiques.

9. Agencement de capteur de champ magnétique (1) selon l'une des revendications 1 à 8 **caractérisé en ce que** la source de champ magnétique (4) entoure de façon annulaire l'au moins un capteur de champ magnétique (3).

10. Agencement de capteur de champ magnétique (1) selon l'une des revendications 1 à 9 **caractérisé en ce que** la au moins une source de champ magnétique (4) et/ou l'axe magnétique de la bobine de calibrage (10) est placé dans et/ou parallèle au plan d'extension de la puce semi-conductrice (2).

11. Agencement de capteur de champ magnétique (1) selon l'une des revendications 1 à 10 **caractérisé en ce que** la au moins une source de champ magnétique (4) et/ou l'axe magnétique de la bobine de calibrage (10) est placé perpendiculaire au plan d'extension de la puce semi-conductrice (2).

12. Agencement de capteur de champ magnétique (1) selon l'une des revendications 1 à 11 **caractérisé en ce qu'**au moins un capteur de champ magnétique (3) est un capteur horizontal à effet Hall et/ou un capteur vertical à effet Hall.

13. Agencement de capteur de champ magnétique (1) selon l'une des revendications 1 à 12 **caractérisé en ce que** dans la puce semi-conductrice (2) est intégré un dispositif de commande et/ou d'exploitation (11), qui présente au moins une entrée de signal de mesure reliée au au moins un capteur de champ magnétique (3).

14. Agencement de capteur de champ magnétique (1) selon l'une des revendications 1 à 13 **caractérisé en ce qu'**au moins une bobine de champ pour la génération d'un champ magnétique alternatif est reliée à une source de courant alternatif et **en ce que** le dispositif de commande ou d'exploitation (11) comporte un dispositif de corrélation qui présente une première entrée reliée au au moins un capteur de champ magnétique (3) et une deuxième entrée reliée à la source de courant alternatif.
